## Europäisches Patentamt
## European Patent Office
## Office européen des brevets

(19)

(11) Veröffentlichungsnummer: **0 218 910**
**B1**

(12) **EUROPÄISCHE PATENTSCHRIFT**

(45) Veröffentlichungstag der Patentschrift:
19.12.90

(51) Int. Cl.⁵: **H03H 7/46**

(21) Anmeldenummer: **86112402.2**

(22) Anmeldetag: **08.09.86**

(54) Frequenzbandtrenner bei Leitungsrichtkopplern für Hochfrequenzenergie.

(30) Priorität: **11.09.85 AT 2658/85**

(43) Veröffentlichungstag der Anmeldung:
**22.04.87 Patentblatt 87/17**

(45) Bekanntmachung des Hinweises auf die Patenterteilung:
**19.12.90 Patentblatt 90/51**

(84) Benannte Vertragsstaaten:
**BE CH DE FR GB LI NL SE**

(56) Entgegenhaltungen:
**DE-A- 3 047 051**

**PATENTS ABSTRACTS OF JAPAN, Band 2, Nr. 106, 31. August 1978, Seite 5596E78; & JP-A-53 071 546 (HITACHI D.K.K.) 26-07-1978 FUNKSCHAU, Band 41, Nr. 12, 2. Juni 1969, Seiten 361-363, München, DE; J. CONRAD: "Grosse Gemeinschaftsantennen-Anlagen verstärkt im Kommen"**

(73) Patentinhaber: **Siemens Aktiengesellschaft, Wittelsbacherplatz 2, D-8000 München 2(DE)**

(72) Erfinder: **Stockinger, Helmut, Russbergstrasse 20/3/3, A-1210 Wien(AT)**

## Beschreibung

Die Erfindung betrifft eine Schaltungsanordnung zum kabelgebundenen Übertragen eines Hochfrequenzsignals auf mindestens einen Richtkoppler, wobei der Eingang der Schaltungsanordnung mit einer Frequenzweiche, bestehend aus einer Parallelschaltung eines Hoch- und eines Tiefpasses, verbunden ist.

Eine derartige Schaltungsanordnung ist aus der DE 30 47 051 A1 und der JP-A 53 071 546 bekannt. Darüberhinaus zeigt die DE 30 22 023 A1 eine Schaltung zum richtungsabhängigen Übertragen von Hochfrequenzenergie. Eine Verbesserung der Übertragung tiefer Frequenzen (LMK-Hörfunkbereich) wird hier dadurch erreicht, daß über ein RC-Glied der Impedanzwert des Ausganges an den gewünschten Widerstand für die tiefen Frequenzen angepaßt und ein Kurzschluß durch Induktivitätsabfall des Übertragers bei diesen Frequenzen verhindert wird.

Dieser Weg ist aber nicht immer gangbar oder vorteilhaft, da der notwendige Signalpegel, insbesondere im unteren MHz-Bereich, nach wie vor recht hoch zu sein scheint. Das ist darin begründet, daß erst bei insgesamt hoher Auskoppeldämpfung die tiefen Frequenzen mit kleiner Dämpfung in die Auskoppelleitung eingespeist werden.

Die Erfindung hat es sich zur Aufgabe gemacht, die Auskoppeldämpfung eines Richtkopplers bei Frequenzen im unteren MHz-Bereich zu reduzieren.

Die erfindungsgemäße Lösung nach Anspruch 1 ist dadurch gekennzeichnet, daß der Hochpaß zur Übertragung eines mittleren und oberen Frequenzbandes des Hochfrequenzsignals mit dem Eingangsanschluß eines ersten Richtkopplers und der Tiefpaß zur Übertragung des unteren Frequenzbandes über eine Einkoppelschaltung direkt mit dem Ausgang des ersten Richtkopplers oder dem angeschlossenen Richtkopplerende verbunden ist und daß die Einkoppelschaltung aus einer Serienschaltung einer Spule mit einem Widerstand besteht, an deren Verbindungsleitung ein Kondensator parallel angeschlossen ist.

Bei dieser Schaltungsanordnung wird die durch die Kabelübertragung bedingte Verzerrung des Frequenzganges dadurch beseitigt, daß ein Richtkoppler mit etwa gegenläufigem Frequenzgang verwendet wird. Dadurch wird eine zusätzliche Erhöhung der Dämpfung infolge einer eigenen Kabelentzerrung vermieden. Bei Serienschaltung mehrerer Richtkoppler, beispielsweise bei Hausanlagen mit Gemeinschaftsantenne, sind keine weiteren Frequenzweichen mehr erforderlich. Lediglich die Übertragung des unteren Frequenzbandes hat über die entsprechende Anzahl von Spulen mit Kondensatoren und Widerständen zu den parallel geschalteten Ausgängen der Richtkoppler zu erfolgen.

Eine getrennte Zuleitung einzelner Hochfrequenzbänder zu unterschiedlichen Richtkopplern ist dadurch möglich, daß die Frequenzweiche als erste Frequenzweiche derart ausgebildet ist, daß ihr Hochpaß zur Übertragung des oberen Frequenzbandes mit dem Eingangsanschluß des ersten Richtkopplers verbunden ist und eine zweite und dritte Frequenzweiche zueinander parallel ihrem Tiefpaß nachgeordnet sind, wobei der Hochpaß der zweiten Frequenzweiche zur gemeinsamen Übertragung des mittleren mit dem oberen Frequenzband gleichfalls mit dem Eingangsanschluß des Richtkopplers verbunden und der Tiefpaß der zweiten Frequenzweiche zur Übertragung des unteren Frequenzbandes über eine Einkoppelschaltung mit dem Ausgang des ersten Richtkopplers oder dem abgeschlossenen Richtkopplerende verbunden ist und wobei der Hochpaß der dritten Frequenzweiche zur Übertragung des mittleren Frequenzbandes mit dem Eingangsanschluß eines zweiten Richtkopplers und der Tiefpaß der dritten Frequenzweiche zur Übertragung des unteren Frequenzbandes über eine Einkoppelschaltung direkt mit dem Ausgang des zweiten Richtkopplers oder dessen abgeschlossenem Ende verbunden ist. Durch diese Schaltungsmaßnahme wird die Auftrennung in einzelne Hochfrequenzbänder dazu benutzt, beispielsweise eigens zu bezahlende Fernsehprogramme nur den jeweiligen Kunden zugänglich zu machen. Auch hier kann die Anzahl der hintereinander zu schaltenden ersten und/oder zweiten Richtkoppler auf einfache Weise variiert werden. Die Verteilerdämpfung gelangt nur auf den Richtkoppler mit den tieferen Frequenzbändern und erhöht so die Entkoppelung der beiden Richtkoppler mit den unterschiedlichen Übertragungsbereichen.

Ein Übertrager vor der Einkoppelschaltung verbessert den Empfang des unteren Frequenzbandes, ein Entzerrer im Leitungsbereich des oberen Frequenzbandes verbessert den Ausgleich des Frequenzganges. Eine vierte Frequenzweiche wird dem ersten Richtkoppler derart vorgeschaltet, daß der Hochpaß der vierten Frequenzweiche mit dem Hochpaß der ersten Frequenzweiche und der Tiefpaß mit dem Hochpaß der zweiten Frequenzweiche verbunden ist, um das obere mit dem mittleren Frequenzband zusammenzuführen und gleichzeitig deren Trennung gegenüber dem unteren Frequenzband zu verbessern.

Die Maßnahme, einen Dämpfungstiefpaß dem Tiefpaß der ersten Frequenzweiche nachzuordnen, dient einer Verbesserung der Trennung des oberen vom mittleren und unteren Frequenzband. Da der Dämpfungstiefpaß zwischen den Tiefpaß der ersten Frequenzweiche und der dritten Frequenzweiche geschaltet wird, erhöht sich die Entkopplung des ersten Richtkopplers mit allen drei Frequenzbändern vom zweiten mit den beiden tieferen Frequenzbändern bezüglich des oberen Frequenzbandes, was insbesondere der Störungssicherheit der Schaltungsanordnung dient. Diese zweistufige elektronische Trennung der Frequenzbänder durch Dämpfung des Signalpegels des oberen Frequenzbandes ermöglicht auch den eng benachbarten Einbau des ersten und zweiten Richtkopplers, ohne dabei mechanische Mittel wie Trennwände oder Dichtungsmassen zur Störungsunterdrückung verwenden zu müssen.

Die Weiterleitung der tieferen Frequenzbänder zum ersten und zweiten Richtkoppler erfolgt vorteilhafterweise mit einem Differentialübertrager für entkoppelte Verteilung, dessen Eingang mit dem Tiefpaß der ersten Frequenzweiche, ein Ausgang mit der zweiten Frequenzweiche und ein zweiter Ausgang mit dem Dämpfungstiefpaß bzw. der dritten Frequenzweiche verbunden ist. Dadurch wird eine gegenseitige Störung der tiefen Frequenzbänder der beiden Richtkoppler durch Reflexionen verhindert.

Da das Problem einer separaten Kostenabrechnung insbesonders bei Kabelfernsehanlagen mit UKW-Übertragung auftritt, sind die verwendeten Bauteile so zu wählen, daß das untere Frequenzband 5 bis 68 MHz, das mittlere 87,5 bis 300 MHz und das obere 470 bis 860 MHz umfaßt.

Die Erfindung wird anhand von Figuren erläutert. Es zeigen:

Fig. 1 ein schematisches Schaltbild eines ersten Ausführungsbeispieles und

Fig. 2 ein schematisches Schaltbild eines erweiterten, zweiten Ausführungsbeispieles.

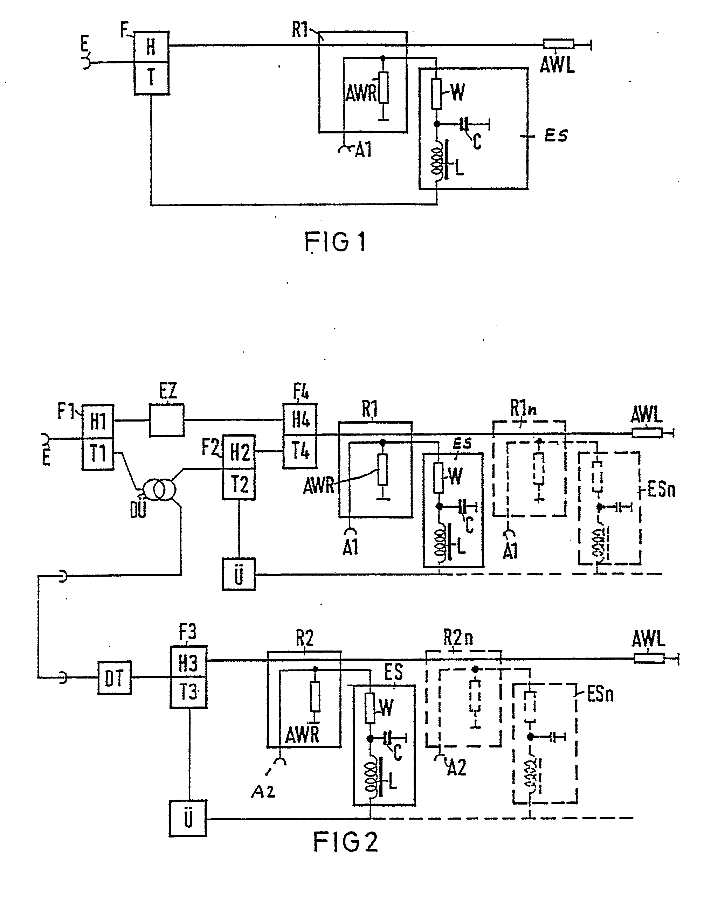

Fig. 1 stellt eine grundlegende Ausgestaltung der Erfindung dar. Einem Eingang E ist ein Hochfrequenzsignal zugeleitet, das beispielsweise alle Fernsehbänder und den UKW-Rundfunk umfaßt und über Kabelanlagen verteilt wird. Eine Frequenzweiche F spaltet das Signal in zwei Bänder auf. Über den Hochpaß H werden die Frequenzen größer 87,5 NHz und über den Tiefpaß T die Frequenzen kleiner 68 MHz weitergeleitet. Der Hochpaß H ist direkt mit dem Eingang eines Richtkopplers R1, der Tiefpaß T zur Einleitung des unteren Frequenzbandes mit einer Einkoppelschaltung ES verbunden. Die Einkoppelschaltung ES bestehend aus einer Serienschaltung einer Spule L mit einem Widerstand W, an deren Verbindungsleitung ein Kondensator C parallel angeschlossen ist. Die Spule L und der Kondensator C dienen nochmals der Bandbegrenzung nach oben und sind entsprechend der Maximalfrequenz des unteren Frequenzbandes zu wählen.

Der Widerstand W bestimmt die Dämpfung des Signalpegels. Die Einkoppelschaltung ES führt das untere Frequenzband über das abgeschlossene Richtkopplerende dem Ausgang A1 zu. Ein Abschlußwiderstand AWR im Richtkoppler R1 ist mit dem Widerstand W und dem Kondensator C parallel geschaltet, wobei die Dimensionierung der einzelnen Widerstände so zu wählen ist, daß der Gesamtwiderstand am abgeschlossenen Richtkopplerende 75 Ohm beträgt. Die Richtkopplerleitung des mittleren und oberen Frequenzbandes endet gleichfalls mit 75 Ohm in einem Abschlußwiderstand AWL. Am Ausgang A1 des Richtkopplers R1 stehen nun infolge der Einkopplung des oberen, mittleren und des unteren Frequenzbandes sämtliche Kanäle des Hochfrequenzsignales zur Verfügung.

Das in Fig. 2 dargestellte zweite Ausführungsbeispiel eignet sich besonders dazu, einzelne Frequenzbänder unterschiedlichen Richtkopplern R1, R2 zuzuleiten. Dadurch ist es beispielsweise bei Kabelfernsehanlagen möglich, separat zu bezahlende Fernsehprogramme an bestimmte Kunden zu liefern.

Der Eingang E ist mit einer ersten Frequenzweiche F1 verbunden, deren Hochpaß H1 mit dem Hochpaß H4 einer vierten Frequenzweiche F4 zur Übertragung des oberen Frequenzbandes von 470 bis 860 MHz verbunden ist. Die Übertragungsqualität dieses Frequenzbandes wird durch einen zwischen die Hochpässe H1, H4 geschalteten Entzerrer EZ verbessert. Das mittlere und untere Frequenzband gelangt vom Tiefpaß T1 der ersten Frequenzweiche F1 an zwei um etwa 20 dB entkoppelte Ausgänge eines Differentialübertragers DÜ. Ein Ausgang führt nun zu einer zweiten Frequenzweiche F2, die das mittlere vom unteren Frequenzband trennt. Das mittlere Frequenzband, 87,5 bis 300 MHz, wird nun dem Tiefpaß T4 der vierten Frequenzweiche F4 zugeleitet, dort mit dem oberen Frequenzband vereinigt und einem Richtkoppler R1 zugeführt, der dem des ersten Ausführungsbeispieles entspricht. Der Tiepaß T2 der zweiten Frequenzweiche F2 ist mit einem Übertrager Ü verbunden, der die Aufgabe hat, die Impedanz an die Anzahl der gegebenenfalls hintereinander geschalteten Richtkoppler R1n anzupassen. Die Zuleitung des unteren Frequenzbandes an den Richtkoppler R1 erfolgt vom Übertrager Ü wie beim ersten Ausführungsbeispiel über eine Einkoppelschaltung ES. Die Richtkopplerleitung des mittleren und oberen Frequenzbandes weist nach Führung durch die Richtkoppler R1, R1n einen Abschlußwiderstand AWL von insgesamt 75 Ohm auf.

Vom zweiten Ausgang des Differentialübertragers DÜ wird nun das mittlere und untere Frequenzband zu einem zweiten Richtkoppler R2 weitergeleitet. Dazu ist der zweite Ausgang des Differentialübertragers DÜ mit einem Dämpfungstiefpaß DT verbunden, der die Frequenzen von 5 bis 300 MHz an eine dritte Frequenzweiche F3 weiterleitet, aber bereits gedämpfte Reste hoher Frequenzen um insgesamt mehr als 55 dB vom unteren und mittleren Frequenzband trennt. Der Hochpaß H3 der dritten Frequenzweiche F3 leitet nun das mittlere Frequenzband von 87,5 bis 300 MHz an einen oder mehrere Richtkoppler R2, R2n weiter. Der Tiefpaß T3 ist wie bei der zweiten Frequenzweiche F2 wiederum mit einem Übertrager Ü verbunden und leitet das untere Frequenzband, 5 bis 68 MHz, über die Einkoppelschaltungen ES, ESn den Ausgängen A2 der Richtkoppler R2, R2n zu. Die Richtkopplerleitung des mittleren Frequenzbandes weist wiederum einen entsprechenden Abschlußwiderstand AWL auf. An den Ausgängen A2 kann somit lediglich das mittlere und untere Frequenzband empfangen werden. Daher ist eine separate Berechnung von Fernsehprogrammen im oberen Frequenzband möglich. Die Trennung des im zweiten Ausführungsbeispiel gezeigten Richtkopplers R1 von dem Richtkoppler R2 beträgt mehr als 40 dB, wobei die Richtkoppler R1, R2 jeweils eine Auskoppeldämpfung von mindestens 10 dB und der Differentialübertrager DÜ eine Entkopplung von 20 dB aufweist.

Durch diese Gestaltung der Schaltungsanordnung kann die erste und vierte Frequenzweiche F1, F4 bzw. die zweite und dritte Frequenzweiche F2, F3 von gleicher Art gewählt werden. Der Dämpfungstiefpaß DT entspricht dem Tiefpaß T1 der ersten Frequenzweiche F1.

Bei den Übertragern Ü und Einkoppelschaltungen ES, ESn sind aber bei der Dimensionierung die jeweiligen Widerstandsverhältnisse zu beachten. *Der Abschluß der Leitungen sollte in den Ausführungsbeispielen 75 Ohm betragen.* Die Einkoppeldämpfung des unteren Frequenzbandes, beispielsweise 26 dB, kann gleich groß sein wie die Auskoppeldämpfung des Richtkopplers bei der eng benachbarten Frequenz des mittleren Frequenzbandes. Durch diese Anordnung wird bei gleicher Kabellänge ein kleinerer Betriebspegel, beispielsweise des Stammverstärkers, benötigt.

## Patentansprüche

1. Schaltungsanordnung zum kabelgebundenen Übertragen eines Hochfrequenzsignals auf mindestens einen Richtkoppler, wobei der Eingang (E) der Schaltungsanordnung mit einer Frequenzweiche (F), bestehend aus einer Parallelschaltung eines Hoch- und eines Tiefpasses (H, T), verbunden ist, dadurch gekennzeichnet, daß der Hochpaß (H) zur Übertragung eines mittleren und oberen Frequenzbandes des Hochfrequenzsignals mit dem Eingangsanschluß eines ersten Richtkopplers (R1) und der Tiefpaß (T) zur Übertragung des unteren Frequenzbandes über eine Einkoppelschaltung (ES) direkt mit dem Ausgang (A1) des ersten Richtkopplers (R1) oder dem angeschlossenen Richtkopplerende verbunden ist und daß die Einkoppelschaltung (ES) aus einer Serienschaltung einer Spule (L) mit einem Widerstand (W) besteht, an deren Verbindungsleitung ein Kondensator (C) parallel angeschlossen ist.

2. Schaltungsanordnung nach Anspruch 1, dadurch gekennzeichnet, daß die Frequenzweiche (F) als erste Frequenzweiche (F1) derart ausgebildet ist, daß ihr Hochpaß (H1) zur Übertragung des oberen Frequenzbandes mit dem Eingangsanschluß des ersten Richtkopplers (R1) verbunden ist und eine zweite und dritte Frequenzweiche (F2, F3) zueinander parallel ihrem Tiefpaß (T1) nachgeordnet sind, wobei der Hochpaß (H2) der zweiten Frequenzweiche (F2) zur gemeinsamen Übertragung des mittleren mit dem oberen Frequenzband gleichfalls mit dem Eingangsanschluß des ersten Richtkopplers (R1) verbunden und der Tiefpaß (T2) der zweiten Frequenzweiche (F2) zur Übertragung des unteren Frequenzbandes über eine Einkoppelschaltung (ES) mit dem Ausgang (A1) des ersten Richtkopplers (R1) oder dessen abgeschlossenem Ende verbunden ist und wobei der Hochpaß (H3) der dritten Frequenzweiche zur Übertragung des mittleren Frequenzbandes mit dem Eingangsanschluß eines zweiten Richtkopplers (R2) und der Tiefpaß (T3) der dritten Frequenzweiche (F3) zur Übertragung des unteren Frequenzbandes über eine Einkoppelschaltung (ES) direkt mit dem Ausgang (A2) des zweiten Richtkopplers (R2) oder dessen abgeschlossenem Ende verbunden ist.

3. Schaltungsanordnung nach Anspruch 1 oder 2, dadurch gekennzeichnet, daß ein Übertrager (Ü) zwischen den Tiefpaß (T, T2, T3) der Frequenzweiche (F) oder der zweiten und/oder dritten Frequenzweiche (F2, F3) und die Einkoppelschaltung (ES), sowie ein Entzerrer hinter den Hochpaß (H1) der ersten Frequenzweiche (F1) geschaltet ist.

4. Schaltungsanordnung nach einem der Ansprüche 2 oder 3, dadurch gekennzeichnet, daß eine vierte Frequenzweiche (F4) dem ersten Richtkoppler (R1) vorgeschaltet ist, wobei der Hochpaß (H4) der vierten Frequenzweiche (F4) mit dem Hochpaß (H1) der ersten Frequenzweiche (F1) und der Tiefpaß (T4) mit dem Hochpaß (H2) der zweiten Frequenzweiche (F2) verbunden ist.

5. Schaltungsanordnung nach einem der Ansprüche 2 bis 4, dadurch gekennzeichnet, daß ein Dämpfungstiefpaß (DT) zwischen den Tiefpaß (T1) der ersten Frequenzweiche (F1) und die dritte Frequenzweiche (F3) geschaltet ist.

6. Schaltungsanordnung nach einem der Ansprüche 2 bis 5, dadurch gekennzeichnet, daß der Eingang eines Differentialübertragers (DÜ) zur entkoppelten Verteilung des Hochfrequenzsignals mit dem Tiefpaß (T1) der ersten Frequenzweiche (F1), ein Ausgang mit der zweiten Frequenzweiche (F2) und ein zweiter Ausgang mit dem Dämpfungstiefpaß (DT) bzw. der dritten Frequenzweiche (F3) verbunden ist.

7. Schaltungsanordnung nach einem der vorherigen Ansprüche, dadurch gekennzeichnet, daß das untere Frequenzband 5 bis 68 MHz, das mittlere 87,5 bis 300 MHz und das obere 470 bis 860 MHz umfaßt.

## Claims

1. Circuit arrangement for the cable-bound transmission of a high-frequency signal onto at least one directional coupler, the input (E) of the circuit arrangement being connected to a frequency filter (F) comprising a parallel circuit of a high-pass and a low-pass filter (H, T), characterized in that for transmitting a middle and upper frequency band of the high-frequency signal the high-pass filter (H) is connected to the input terminal of a first directional coupler (R1), and for transmitting the lower frequency band via a coupling circuit (ES) the low-pass filter (T) is connected directly to the output (A1) of the first directional coupler (R1) or to the connected directional coupler end, and in that the coupling circuit (ES) comprises a series circuit of a coil (L) with a resistor (W), to the connecting line of which a capacitor (C) is connected in parallel.

2. Circuit arrangement according to Claim 1, characterized in that as first frequency filter (F1) the frequency filter (F) is designed in such a way that, for transmitting the upper frequency band, its high-pass filter (H1) is connected to the input terminal of the first directional coupler (R1), and a second and third frequency filter (F2, F3) are arranged parallel to one another to follow its low-pass filter (T1), the high-pass filter (H2) of the second frequency filter (F2) being likewise connected to the input terminal of the first directional coupler (R1) for the common transmission of the middle with the upper frequency band, and the lowpass filter (T2) of the second frequency filter (F2) being connected to the output (A1) of the first directional coupler (R1) or its terminated end for the transmission of the lower frequency band via a coupling circuit (ES), and the high-pass filter (H3) of the third frequency filter being connected to the input terminal of a second directional coupler (R2) for transmitting the middle frequency band, and the low-pass filter (T3) of the third frequency filter (F3) being directly connected to the output (A2) of the second directional coupler (R2) or its terminated end for transmitting the lower frequency band via a coupling circuit (ES).

3. Circuit arrangement according to Claim 1 or 2, characterized in that a transformer (Ü) is connected between the low-pass filter (T, T2, T3) of the frequency filter (F) or the second and/or third frequency filter (F2, F3) and the coupling circuit (ES), and also an equalizer is connected following the high-pass filter (H1) of the first frequency filter (F1).

4. Circuit arrangement according to one of Claims 2 or 3, characterized in that a fourth frequency filter (F4) is connected upstream of the first directional coupler (R1), the high-pass filter (H4) of the fourth frequency filter (F4) being connected to the high-pass filter (H1) of the first frequency filter (F1), and the low-pass filter (T4) being connected to the high-pass filter (H2) of the second frequency filter (F2).

5. Circuit arrangement according to one of Claims 2 to 4, characterized in that an attenuation low-pass filter (DT) is connected between the low-pass filter (T1) of the first frequency filter (F1) and the third frequency filter (F3).

6. Circuit arrangement according to one of Claims 2 to 5, characterized in that, for decoupled splitting of the high-frequency signal, the input of a differential transformer (DÜ) is connected to the low-pass filter (T1) of the first frequency filter (F1), one output is connected to the second frequency filter (F2) and a second output is connected to the attenuation low-pass filter (DT) or the third frequency filter (F3).

7. Circuit arrangement according to one of the preceding claims, characterized in that the lower frequency range covers 5 to 68 MHz, the middle range covers 87.5 to 300 MHz and the upper range covers 470 to 860 MHz.

**Revendications**

1. Montage pour transmettre par câble un signal à haute fréquence à au moins un coupleur directionnel, l'entrée (E) du montage étant reliée à un filtre d'aiguillage (F) constitué par un montage en parallèle formé d'un filtre passe-haut et d'un filtre passe-bas (H, T), caractérisé par le fait que le filtre passe-haut (H) est relié à une borne d'entrée d'un premier coupleur directionnel (R1) pour la transmission d'une bande moyenne et d'une bande supérieure de fréquences du signal à haute fréquence et que le filtre passe-bas (T) est relié directement à la sortie (A1) du premier coupleur directionnel (R1) ou à l'extrémité raccordée du coupleur directionnel, pour la transmission de la bande inférieure de fréquences par l'intermédiaire d'un circuit d'injection par couplage (ES), et que le circuit d'injection par couplage (ES) est constitué par un circuit série formé d'une bobine (L) et en parallèle avec la ligne de raccordement duquel est branché un condensateur (C).

2. Montage suivant la revendication 1, caractérisé par le fait que le filtre d'aiguillage (F) est réalisé sous la forme d'un premier filtre d'aiguillage (F1) de telle sorte que son filtre passe-haut (H1) pour la transmission de la bande supérieure de fréquences est relié à la borne d'entrée du premier coupleur directionnel (R1) et des second et troisième filtres d'aiguillage (F2, F3) sont branchés en parallèle entre eux, en aval de leur filtre passe-bas (T1), le filtre passe-haut (H2) du second filtre d'aiguillage (F2) étant également relié à la borne d'entrée du premier coupleur directionnel (R1) pour la transmission en commun des bandes moyennes et supérieures de fréquences, tandis que le filtre passe-haut (T2) du second filtre d'aiguillage (F2) est relié par l'intermédiaire d'un circuit d'injection par couplage (ES) à la sortie (A1) du premier coupleur directionnel (R1) ou à l'extrémité de terminaison de ce coupleur, pour la transmission de la bande inférieure de fréquences et que le filtre passe-haut (H3) du troisième filtre d'aiguillage est raccordé à la borne d'entrée d'un second coupleur directionnel (R2) pour la transmission de la bande moyenne de fréquences et que le filtre passe-bas (T3) du troisième filtre d'aiguillage (F3) est raccordé directement, par l'intermédiaire d'un circuit d'injection par couplage (ES), à la sortie (A2) du second coupleur directionnel (R2) ou à l'extrémité fermée de ce coupleur, pour la transmission de la bande inférieure de fréquences.

3. Montage suivant la revendication 1 ou 2, caractérisé par le fait qu'un transformateur (U) est branché entre les filtres passe-bas (T, T2, T3) du filtre d'aiguillage (F) ou le second et/ou le troisième filtre d'aiguillage (F2, F3) et le circuit d'injection par couplage (ES), ainsi qu'un égaliseur branché en aval du filtre passe-haut (H1) du second filtre d'aiguillage (F1).

4. Montage suivant l'une des revendications 2 ou 3, caractérisé par le fait qu'un quatrième filtre d'aiguillage (F4) est branché en amont du premier coupleur directionnel (R1), le filtre passe-haut (H4) du premier filtre d'aiguillage (F4) étant relié au filtre passe-haut (H1) du premier filtre d'aiguillage (F1), tandis que le filtre passe-bas (T4) est relié au filtre passe-haut (F2) du second filtre d'aiguillage (F2).

5. Montage suivant l'une des revendications 2 à 4, caractérisé par le fait qu'un filtre passe-bas d'atténuation (DT) est branché entre le filtre passe-bas (T1) du premier filtre d'aiguillage (F1) et le troisième filtre d'aiguillage (F3).

6. Montage suivant l'une des revendications 2 à 5, caractérisé par le fait que l'entrée d'un transformateur différentiel (DU) est raccordée, pour la répartition découplée du signal à haute fréquence, au filtre passe-bas (T1) du premier filtre d'aiguillage (F1), qu'une sortie est reliée au second filtre d'aiguillage (F2) et qu'une seconde sortie est reliée au filtre passe-bas d'atténuation (19) ou au troisième filtre d'aiguillage (F3).

7. Montage suivant les revendications précédentes, caractérisé par le fait que la bande inférieure de fréquences s'étend de 5 à 68 MHz, que la seconde bande de fréquences s'étend de 87,5 à 300 MHz et que la troisième bande de fréquences s'étend de 470 à 860 MHz.

FIG 1

FIG 2